Europäisches Patentamt

European Patent Office

Office européen des brevets

(11) Veröffentlichungsnummer: **0 250 865
B1**

# EUROPÄISCHE PATENTSCHRIFT

(45) Veröffentlichungstag der Patentschrift:
25.07.90

(51) Int. Cl.⁵: **C23C 30/00,** C23C 16/30,
B23B 27/14

(21) Anmeldenummer: 87107635.2

(22) Anmeldetag: 26.05.87

(54) Schneidwerkzeug.

(30) Priorität: 21.06.86 DE 3620901

(43) Veröffentlichungstag der Anmeldung:
07.01.88 Patentblatt 88/1

(45) Bekanntmachung des Hinweises auf die Patenterteilung:
25.07.90 Patentblatt 90/30

(84) Benannte Vertragsstaaten:
AT DE FR GB

(56) Entgegenhaltungen:
EP-A- 0 095 128
FR-A- 2 370 551
US-A- 4 101 703

PATENT ABSTRACTS OF JAPAN, Band 2, Nr. 46, 28.
März 1978; & JP-A-53 1112 (SUMIMOTO DENKI KOGYO
K.K.) 07-01-1978
PATENT ABSTRACTS OF JAPAN, Band 2, Nr. 46, 28.
März 1978; & JP-A-53 3906 (SUMIMOTO DENKI KOGYO
K.K.) 14-01-1978
PATENT ABSTRACTS OF JAPAN, Band 9,
Nr. 228 (C-303)[1951], 13. September 1985; &
JP-A-60 89 565 (SEIKO DENSHI KOGYO K.K.) 20-05-1985

Die Akte enthält technische Angaben, die nach dem
Eingang der Anmeldung eingereicht wurden und die
nicht in dieser Patentschrift enthalten sind.

(73) Patentinhaber: Fried. Krupp Gesellschaft mit
beschränkter Haftung, Altendorfer Strasse 103,
D-4300 Essen 1(DE)

(72) Erfinder: van den Berg, Henrikus, Dr.rer.nat.,
Hans-Niemeyer-Strasse 8, D-4300 Essen 1(DE)
Erfinder: König, Udo, Dr.rer.nat., Helgolandring 31,
D-4300 Essen 1(DE)
Erfinder: Reiter, Norbert, Dr., Hunsrückstrasse 29,
D-4020 Mettmann(DE)

(74) Vertreter: Vomberg, Friedhelm, Dipl.-Phys.,
Graf-Recke-Strasse 231, D-4000 Düsseldorf 1(DE)

**Beschreibung**

Die Erfindung betrifft ein Schneidwerkzeug, auf dessen mit Titancarbid, Titancarbonitrid und/oder Titannitrid beschichtete Schneide eine äußere Deckschicht aus Zirkoniumnitrid aufgebracht ist.

Es ist bekannt, daß man Schneidwerkzeuge, insbesondere solche aus Hartmetall mit Schichten aus Titancarbid, Titancarbonitrid und/oder Titannitrid versehen und dadurch eine Verschleißfestigkeit dieser Werkzeuge erheblich verbessern kann. Die Verwendung bindemetallfreier Hartstoffschichten aus Nitriden und Carbonitriden der Elemente der IV. bis VI. Nebengruppe des Periodensystems zum Verschleißschutz von Werkzeugen aus Hartmetallen ist beispielsweise aus der deutschen Patentschrift 1 959 690 bekanntgeworden und es haben sich aus der genannten Gruppe der Hartstoffe besonders die Hartstoffe auf der Basis des Elementes Titan gut in der Praxis bewährt. Eine weitere Leistungssteigerung von Schneidwerkzeugen aus Hartmetallen kann nach dem Vorschlag der deutschen Patentschrift 2 263 210 durch eine Mehrlagenbeschichtung aus Titancarbid, Titancarbonitrid und Titannitrid erzielt werden. Wendeschneidplatten aus Hartmetallen mit einem Überzug von mehreren Schichten aus Titancarbid, Titancarbonitrid und Titannitrid sind besonders für die Drehbearbeitung von Stählen bei mittleren Schnittgeschwindigkeiten geeignet. Höhere Schnittgeschwindigkeiten verursachen aber hohe Temperaturen an den Schneidecken der Schneidwerkzeuge, wodurch ein rasch fortschreitender Diffusions- und Oxidationsverschleiß eintritt. Es ist deshalb bereits vorgeschlagen worden, für diesen Anwendungsfall die Lebensdauer entsprechender Schneidwerkzeuge dadurch zu erhöhen, daß auf ihnen dünne Schichten aus Aluminiumoxid aufgebracht werden. Beim derzeitigen Stand der Technik haben sich für mittlere Schnittgeschwindigkeiten und große Spanquerschnitte mit Titancarbid, Titancarbonitrid und Titannitrid beschichtete Schneideinsätze durchgesetzt, bei hohen Schnittgeschwindigkeiten kommen Beschichtungen aus Oxiden der Elemente Aluminium oder Zirkon, vielfach auch in Kombination mit einer Beschichtung mit den Nitriden und Carbiden des Titans bevorzugt zum Einsatz.

Nach der JP 531 112 ist ein Schneidwerkzeug mit einer Zirkonnitridschicht als Deckschicht auf einer Basisbeschichtung aus Titancarbid bekannt, bei der die Dicke der Deckschicht 25 bis 66% der Basisbeschichtung beträgt.

Die vorliegende Erfindung bezweckt Schneidwerkzeuge mit noch höherer Gebrauchsdauer zu schaffen.

Diese Aufgabe wird durch ein Scheidwerkzeug, auf dessen mit Titancarbid, Titancarbonitrid und/oder Titannitrid beschichtete Schneide eine äußere Deckschicht aus Zirkoniumnitrid aufgebracht ist, welches dadurch gekennzeichnet ist, daß die Dicke der äußeren Deckschicht 1% bis 10% der mindestens 6 µm dicken Basisbeschichtung aus Titancarbid, Titancarbonitrid und/oder Titannitrid maximal aber 1 µm beträgt, gelöst.

Solche Schneidkörper nach der Erfindung weisen eine erheblich erhöhte Gebrauchsdauer bei mittleren bis hohen Schnittgeschwindigkeiten auf.

Die Erfindung wird nachfolgend anhand von Ausführungsbeispielen näher erläutert.

Eine Wendeschneidplatte aus Hartmetall mit der Zusammensetzung 82,5 % W, 11 % (Ti, Ta, Nb)C und 6,5 % Co (Massenprozente) wurde nach dem Verfahren der chemischen Abscheidung aus der Gasphase (CVD-Verfahren) in einer entsprechenden Apparatur mit zwei aufeinanderfolgenden Lagen aus Titancarbonitrid beschichtet. Die für die Abscheidung benötigten Gasgemische aus Titantetrachlorid, Wasserstoff, Methan und Stickstoff wurden so gewählt, daß die innere Schicht aus Titancarbonitrid eine höhere Kohlenstoffkonzentration als die äußere Schicht aufwies.

Das Reaktionsgefäß aus hitzebeständigem Stahl der CVD-Apparatur besaß ein Volumen von etwa 30 l und wurde durch einen übergestülpten elektrischen Ofen auf eine Temperatur von 1000 °C erhitzt. Zur Durchführung der chemischen Abscheidung aus der Gasphase ist in das Reaktorgefäß ein Gasgemisch eingeleitet worden, welches die in der nachfolgenden Tabelle aufgeführten Gase enthielt. In dieser Tabelle sind außerdem die gewählten Gasmengen, Drucke und Temperaturen aufgeführt.

Tabelle 1

|  | 1. Schicht Gasmenge (Ltr./Std.) | 2. Schicht Gasmenge |
|---|---|---|
| $TiCl_4$ | 5 | 10 |
| $H_2$ | 350 | 530 |
| $CH_4$ | 60 | 60 |
| $N_2$ | 130 | 238 |
| Temperatur | 990°C | 990°C |
| Druck | 500 hPa | 700 hPa |

Zur Beschleunigung der Abscheidung und zur Erzielung eines feinkörnigen Schichtgefüges ist ein katalytisch wirkendes Aluminiumhalogenid-Additiv in die Gasatmosphäre eingeleitet worden.

Nach einer Zeitdauer von insgesamt 300 Minuten ist die Zufuhr des Titantetrachlorids und des Methans abgestellt worden. Zur Abscheidung einer Schicht aus Zirkonnitrid ist anschließend ein Gasgemisch aus 370 l/h Wasserstoff, 330 l/h Stickstoff und 5 l/h Zirkontetrachlorid in das Reaktionsgefäß eingeleitet worden, wobei die Temperatur während dieses Prozeßschrittes auf 1010 °C erhöht worden ist. Der Druck im Gefäßinnern betrug 700 hPa. Nach Ablauf von 60 Minuten wurde die Zufuhr aller Gase mit Ausnahme des Wasserstoffs abgestellt und das Reaktionsgefäß abgekühlt. Nach Entfernen des Wasserstoffgases wurde das Gefäß belüftet und geöffnet, und die nunmehr beschichteten Hartmetallkörper entnommen. Die Dicke der beiden Schichten aus Titancarbonitrid lag je nach Lage der Proben im Reaktionsgefäß zwischen 9 µm und 12 µm, während die äußere Zirkonnitridschicht, die wegen ihrer charakteristischen gelben Farbe gut vom Titancarbonitrid unterschieden werden kann, eine Dicke von etwa 0,7 bis 1 µm aufwies.

Zur Prüfung der Verschleißbeständigkeit der erfindungsgemäß beschichteten Wendeschneidplatten wurde deren Standzeit durch die Zerspanung der Stahlwerkstoffe C60N und 42CrMo4 durch Drehen im glatten Schnitt bei verschiedenen Schnittgeschwindigkeiten bestimmt. Der Drehtest wurde nach bestimmten Zeitintervallen unterbrochen und die Zunahme des Verschleißes der Schneidecke durch Messung der Kolktiefe $K_t$ und der Verschleißmarkenbreite Vb bestimmt. Danach wurde der Versuch fortgesetzt. Als Kriterium für das Standzeitende der Wendeschneidplatten ist die Schnittzeit bis zum Erreichen einer Kolktiefe von $K_t$ = 60 µm bzw. einer Verschleißmarkenbreite von Vb = 0,2 mm festgesetzt worden. Die Schnittiefe $a_p$= 1,5 mm und der Vorschub f = 0,28 mm/U sowie die übrigen geometrischen Einstellungen wurden während der Versuche konstant gehalten. Zum Vergleich und zur Beurteilung dieser Versuche sind handelsübliche Wendeschneidplatten gleicher Plattenform und aus der gleichen Hartmetallegierung untersucht worden, die nach bekannten Fertigungs verfahren beschichtet worden sind und die die erfindungsgemäße Deckschicht aus Zirkonnitrid nicht aufgewiesen haben. Zur Bearbeitung des Werkstoffes C60N wurden zwei Varianten ausgewählt, und zwar als Beschichtung A eine Beschichtung aus Titancarbid, Titancarbonitrid mit nach außen zunehmendem Stickstoffgehalt und mit einer weiteren Schicht aus Titannitrid mit einer Gesamtschichtdicke von 10 µm sowie als Beschichtung B eine Beschichtung aus Titancarbid, Titancarbonitrid und Titannitrid mit vier etwa 2 µm dicken keramischen Schichten aus Aluminiumoxidnitrid, die durch dünne Zwischenschichten aus Titannitrid abgegrenzt waren. Die Gesamtdicke dieser Viellagenbeschichtung betrug 11 µm. Wendeschneidplatten mit der Beschichtung A haben sich bei mittleren Schnittgeschwindigkeiten und großen Spanungsquerschnitten bewährt, während solche mit der Beschichtung B bei hohen Schnittgeschwindigkeiten ausgezeichnete Standzeiten aufgewiesen haben.

Das Ergebnis der Schneidhaltigkeitsuntersuchung ist in nachfolgender Tabelle 2 angegeben.

Tabelle 2

Standzeit von beschichteten Wendeschneidplatten beim Drehen von Stahl C6ON.

| | |
|---|---|
| Substrathartmetall: | M 15 |
| Ausführung der Schneidplatte: | SNMA 120408 |
| Schnittiefe: | 1,5 mm |
| Vorschub: | 0,28 mm/Umdrehung |

| Beschichtung | Schichtdicke (µm) | Schnittgeschwindigkeit (m/min) | Standzeit (min) |
|---|---|---|---|
| A | 10,8 | 180 | 30 |
| | | 224 | 14 |
| B | 11,2 | 180 | 36 |
| | | 224 | 18 |
| C (erfindungs- gemäß) | 9,2 | 180 | 62 |
| | | 224 | 22 |

Bei einer Schnittgeschwindigkeit von 180 m/Minuten sind die Standzeiten der beiden Beschichtungen A und B nach dem Stand der Technik von der Standzeit der Beschichtung C nach der Erfindung weit übertroffen worden. Bei der höheren Schnittgeschwindigkeit von 224 m/Minuten sind die Standzeiten als Folge der höheren Schneidentemperatur niedriger, aber auch in diesem Falle erreichte die erfindungsgemäß beschichtete Schneidplatte die höchste Standzeit der untersuchten Schneidplatten. Bei der Bearbeitung des legierten Stahles 42CrMo4V wurden die in nachfolgender Tabelle 3 dargestellten Ergebnisse erzielt.

# EP 0 250 865 B1

## Tabelle 3

Standzeit von beschichteten Wendeschneidplatten beim Drehen des legierten Stahles 42CrMo4V.

| | |
|---|---|
| Substrathartmetall: | M 15 |
| Form der Schneidplatte: | SNMA 120408 |
| Schnittiefe: | 1,5 mm |
| Vorschub: | 0,28 mm/Umdrehung |

| Beschichtung | Schichtdicke (μm) | Schnittgeschwindigkeit (m/min) | Standzeit (min) |
|---|---|---|---|
| B | 10,6 | 224 | 18 |
| | | 250 | 13 |
| C (erfindungs- gemäß) | 9,0 | 224 | 32 |
| | | 250 | 17 |

Um den Effekt der dünnen äußeren Schicht aus Zirkonnitrid besser erkennen zu können, sind in der oben beschriebenen Weise in zwei weiteren Beschichtungszyklen etwa 10 μm dicke Einzelschichten aus Titannitrid abgeschieden worden, wobei in einem Falle auf das Aufbringen der dünnen Deckschicht aus Zirkonnitrid verzichtet worden ist. Aus der Menge der beschichteten Wendeschneidplatten der beiden Versuche wurde Paare herausgesucht, die jeweils exakt die gleiche Gesamtschichtdicke besaßen und es wurden mit diesen Platten wiederum vergleichende Schneidhaltigkeitsversuche angestellt, deren Versuchsparameter sowie Ergebnisse in der dieser Beschreibung am Ende angefügten Tabelle 4 dargestellt sind. Es zeigt sich aus dieser Tabelle, daß die Schneidkörper mit der erfindungsgemäßen Deckschicht nach einer Drehzeit von 16 Minuten Kolktiefen $K_T$ aufweisen, die um 30 bis 40 % niedriger als bei der gleich dicken Titannitridschicht ohne Deckschicht aus Zirkonnitrid liegen. Dieser Vorteil zeigt sich sowohl beim Zerspanen des Stahles C60N als auch beim Zerspanen des legierten Stahles 42CrMo4V.

Es sind schließlich auch noch Versuche mit einer dickeren ca. 2 bis 3 μm dicken Deckschicht aus Zirkonnitrid auf Titancarbonitridbeschichtungen von 9 μm Dicke unternommen worden. Auch hier haben sich Verbesserungen im Schneidhaltigkeitsverhalten gezeigt, die in ihrem Ausmaß die Effekte einer dünnen Deckschicht jedoch nicht wesentlich übertroffen haben. Es kommt also in erster Linie nicht so sehr auf die Dicke der äußeren Schicht aus Zirkonnitrid, sondern darauf an, daß diese Schicht die Basisbeschichtung vollständig bedeckt.

Weitere Versuche haben im übrigen die Annahme bestätigt, daß nicht die Verwendung einer Beschichtung aus Zirkonnitrid allein den von der Erfindung erzielten Erfolg erreicht, sondern die Kombination einer relativ dicken Beschichtung mit anderen Hartstoffen wie Titancarbid, Titancarbonitrid und/oder Titannitrid mit der dünnen äußeren Deckschicht aus Zirkonnitrid.

Als Verfahren zur Abscheidung der Zirkonnitriddeckschicht eignet sich neben dem CVD-Verfahren auch das sogenannte PVD-Verfahren.

4

**Tabelle 4**

$V_c$ = 224 m/min          Plattenform   SNMA   120408

$t_c$ = 16 min              Substrat        AT15 (N 15)

$a_p$ = 1,5 mm

$f$ = 0,28 mm/Umdrehung

KT | VB

$\mu m$ | mm

C 60 N                                    42 Cr Mo 4V

40 — 0,4

30 — 0,3

20 — 0,2

10 — 0,1

TiN          TiN+ ZrN          TiN          TiN+ZrN

d[$\mu m$]  10,5        9,9 + 0,6          10,5        9,9+0,6

## Patentansprüche

1. Schneidewerkzeug, auf dessen mit Titancarbid, Titancarbonitrid und/oder Titannitrid beschichtete Schneide eine äußere Deckschicht aus Zirkoniumnitrid aufgebracht ist, dadurch gekennzeichnet, daß die Dicke der äußeren Deckschicht 1% bis 10% der mindestens 6 μm dicken Basisbeschichtung aus Titancarbid, Titancarbonitrid und/oder Titannitrid maximal aber 1 μm beträgt.

2. Schneidwerkzeug nach Anspruch 1, dadurch gekennzeichnet, daß dessen Grundkörper aus einem Hartmetall besteht, das im wesentlichen Wolframcarbid und ein Hilfsmetall der Eisengruppe enthält.

3. Schneidwerkzeug nach Anspruch 1, **dadurch gekennzeichnet**, daß die äußere Zirkonnitridschicht durch Anwendung des CVD-Verfahrens aufgebracht ist.

4. Schneidwerkzeug nach Anspruch 1, dadurch gekennzeichnet, daß die äußere Deckschicht aus Zirkonnitrid mit Hilfe des PVD-Verfahrens aufgebracht ist.

## Claims

1. A cutting tool to whose cutting edge, coated with titanium carbide, titanium carbonitride and/or titanium nitride, an outer cover layer of zirconium nitride is applied, characterized in that the thickness of the outer cover layer is 1% to 10% of the 6 μm thick base coating of titanium carbide, titanium carbonitride and/or titanium nitride, but at most 1 μm.

2. A cutting tool according to claim 1, characterized in that its base element is made of a hard metal mainly containing tungsten carbide and an auxiliary metal of the iron group.

3. A cutting tool according to claim 1, characterized in that the outer layer of zirconium nitride is applied by the use of the CVD process.

4. A cutting tool according to claim 1, characterized in that the outer cover layer of zirconium nitride is applied using the PVD process.

## Revendications

1. Outil de coupe, comportant un taillant recouvert d'une couche de carbonitrure de titane et/ou de nitrure de titane, sur lequel est rapportée une couche externe de recouvrement en nitrure de zirconium, caractérisé en ce que l'épaisseur de la couche externe de recouvrement est de 1% à 10% de la couche de base, ayant au moins 6 microns d'épaisseur, en carbure de titane, carbonitrure de titane et/ou nitrure de titane, mais en ce qu'elle est au maximum de 1 micron.

2. Outil de coupe suivant la revendication 1, caractérisé en ce que son corps de base est constitué par un métal dur, contenant essentiellement du carbure de tungstène et un métal d'appoint du groupe du fer.

3. Outil de coupe suivant la revendication 1, caractérisé en ce que la couche externe de nitrure de zirconium est déposée en utilisant le procédé CVD.

4. Outil de coupe suivant la revendication 1, caractérisé en ce que la couche externe de nitrure de zirconium est déposée à l'aide du procédé PVD.